# FASCICULE DE BREVET EUROPEEN

(11) **EP 0 733 268 B1**
(45) Date de publication et mention de la délivrance du brevet: **24.02.1999**
(21) Numéro de dépôt: 95934181.9
(22) Date de dépôt: 06.10.1995
(51) Int. Cl.: H01L 21/60

(54) **PROCEDE D'ECHANGE D'UN MODULE DE DETECTION HYBRIDE PAR DES BILLES DE SOUDURE**
VERFAHREN ZUM AUSTAUSCH EINES DETEKTORMODULES MONTIERT MITTELS LOTKUGELN
METHOD FOR REPLACING A DETECTION MODULE HYBRIDIZED BY WELDING BALLS

(30) Priorité: 06.10.1994 FR 9411948
(43) Date de publication de la demande: 25.09.1996
(73) Titulaire: COMMISSARIAT A L'ENERGIE ATOMIQUE, 75015 Paris (FR)
(72) Inventeur: RAVETTO, Michel, F-38240 Meylan (FR); CHAMONAL, Jean-Paul, F-38330 Saint-Ismier (FR); MARION, François, F-38120 Saint-Egrève (FR); PORNIN, Jean-Louis, F-38920 Crolles (FR)
(74) Mandataire: Dubois-Chabert, Guy
(86) Numéro de dépôt international: FR9501306
(87) Numéro de publication internationale: WO9611497

(56) Documents cités:
- PATENT ABSTRACTS OF JAPAN vol. 17 no. 599 (E-1455) ,2 Novembre 1993 & JP,A,05 183011 (CASIO COMPUT) 23 Juillet 1993,
- IBM TECHNICAL DISCLOSURE BULLETIN, vol. 25, no. 2, Juillet 1982 NEW YORK US, pages 752-753, C.L. JOHNSON ET AL. 'Substrate Wiring Patterns for Partial-Good Integrated-Circuit Chips'
- 27th ECC, Arlington, VA, May 16-18, 1977, pages 25-29, L.S. GOLDMANN et al.: "Lead-Indium for Controlled-Collapse Chip Joining"

## Description

La présente invention concerne un procédé d'échange d'un module de détection d'un rayonnement, qui est hybridé par des billes de soudure.

Elle s'applique aux domaines de la micro-électronique et de l'opto-électronique.

Le rayonnement peut être un rayonnement infrarouge, un rayonnement X ou un rayonnement γ.

La présente invention permet par exemple la réparation d'un dispositif micro-électronique, constitué de plusieurs modules élémentaires, par exemple des modules de détection de rayonnement infrarouge, lorsque le dispositif ne fonctionne plus parce que l'un des modules est défectueux.

Les éléments de détection infrarouge (encore appelés "pixels" ou "photosites") de chaque module se trouvent situés dans un plan appelé "plan de détection du dispositif micro-électronique". La réparation de ce dernier, qui passe par l'échange du module défectueux, doit permettre de retrouver des éléments de détection identiques dans une position spatiale très précise de façon à ce qu'ils se trouvent exactement disposés (selon trois axes orthogonaux x, y, z) comme l'étaient les éléments de déjection du module remplacé et toujours dans le plan de détection du dispositif.

Ces modules sont aboutés et hybridés par des billes de soudure, selon la technologie dite "flip-chip", à un support de réseau d'interconnexion ou de circuit de lecture par exemple.

L'invention permet de remplacer le module défectueux par un module du même type, sans modifier les spécifications initiales du dispositif.

Le procédé objet de l'invention respecte toutes les spécifications électriques mais vise tout particulièrement à respecter des spécifications très précises de positionnement spatial (suivant x, y et z) des pixels du module qui remplace un module défectueux et qui a été réhybridé sur le support du réseau d'interconnexion du dispositif micro-électronique.

Les dispositifs micro-électroniques du genre de celui dont il a été question plus haut sont très coûteux d'une part parce qu'ils résultent d'une technologie micro-électronique complexe, les fréquences de fonctionnement étant de plus en plus élevées, et d'autre part parce que ces dispositifs comprennent un nombre de plus en plus grand de modules élémentaires que l'on souhaite regrouper dans un même système pour améliorer les performances globales de celui-ci.

Il est en outre très difficile de réaliser de tels dispositifs micro-électroniques.

Leur fabrication peut tout simplement être remise en cause si l'on ne se donne pas les moyens d'échanger, après assemblage et mesures, un ou plusieurs modules élémentaires qui s'avéreraient être défectueux ou non conformes aux spécifications fournies par l'utilisateur.

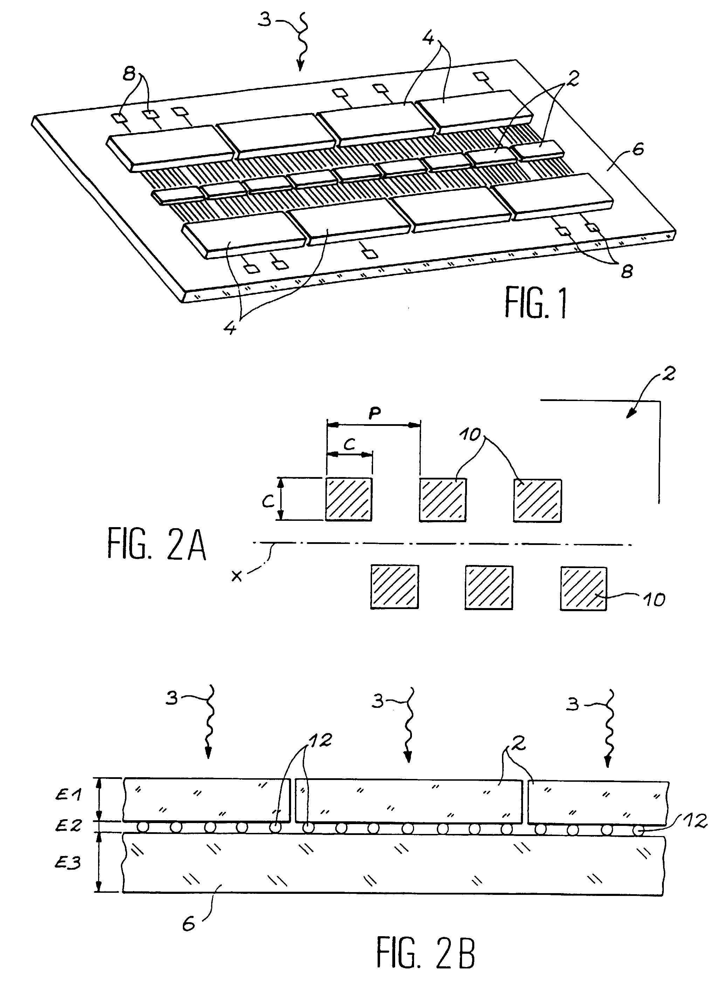

Considérons par exemple un dispositif de détection infrarouge qui est schématiquement représenté sur la figure 1.

Ce dispositif de détection comprend des modules 2 de détection d'un rayonnement infrarouge 3, que l'on aboute les uns aux autres pour obtenir une "ligne continue" de pixels de détection (non représentés) encore appelés "photosites", sans perte de pas et qui se trouvent dans une position spatiale très précise les uns par rapport aux autres.

Le matériau CMT/CZT (C pour cadmium, M pour mercure, T pour tellure et Z pour zinc), sur lequel sont réalisés ces photosites, et le rendement de fabrication obtenu sont des conditions qui définissent la taille relativement petite de chacun des modules de détection 2.

Le dispositif schématiquement représenté sur la figure 1 comprend également des modules 4 de lecture des informations fournies par les photosites.

Ces modules de lecture 4 sont réalisés sur du silicium et disposés de part et d'autre des modules de détection 2.

Tous les modules 2 et 4 sont hybridés par des billes d'indium (non représentées) sur un support de réseau d'interconnexion 6 en silicium ou en saphir.

On voit également sur la figure 1 des connexions d'entrée-sortie 8 dont est pourvu le support de réseau d'interconnexion 6.

Les modules 2 et 4 sont hybridés au support 6 par une technique d'auto-alignement qui est décrite dans le document suivant auquel on se reportera :

Demande de brevet français n° 8905542 du 26 Avril 1989 (voir aussi EP-A-0395488 et US-A-5131584).

Le support de réseau d'interconnexion 6 permet de replier électriquement, sur de courtes distances, les modules les uns aux autres, et de réaliser des interfaces d'entrée-sortie du dispositif.

La figure 2A est une vue schématique et partielle de la face de l'un des modules de détection 2, du côté de laquelle se trouvent les photosites.

On voit sur cette figure 2A certains de ces photosites 10 du module, qui sont disposés en quinconce et définissent ainsi un plan de détection.

On voit également sur la figure 2A l'axe médian X du module de détection 2, de part et d'autre duquel se trouvent les photosites.

La figure 2B est une vue en coupe schématique et partielle des modules de détection 2 qui sont aboutés et hybridés au support de réseau d'interconnexion 6 par des billes 12 en indium.

On utilise typiquement les valeurs suivantes pour le dispositif des figures 1 à 2B :
- dimension de chaque module de détection : 3x9 mm²,
- photosite de forme carrée de côté C égal à 40 µm,
- disposition en quinconce des photosites au pas P de 80 µm,
- épaisseur E1 de chaque module de détection 2 : 400 µm,
- épaisseur E2 des billes d'indium : 20 µm,
- épaisseur E3 du support du réseau d'interconnexion : 500 µm.

Grâce à la technique d'auto-alignement mentionnée plus haut, tous les modules respectent, après hybridation, des spécifications très précises de position spatiale, définies par le volume des billes d'indium et par les surfaces mouillables qui sont réalisées sur le support de réseau d'interconnexion en silicium 6 et auxquelles sont fixées les billes d'indium.

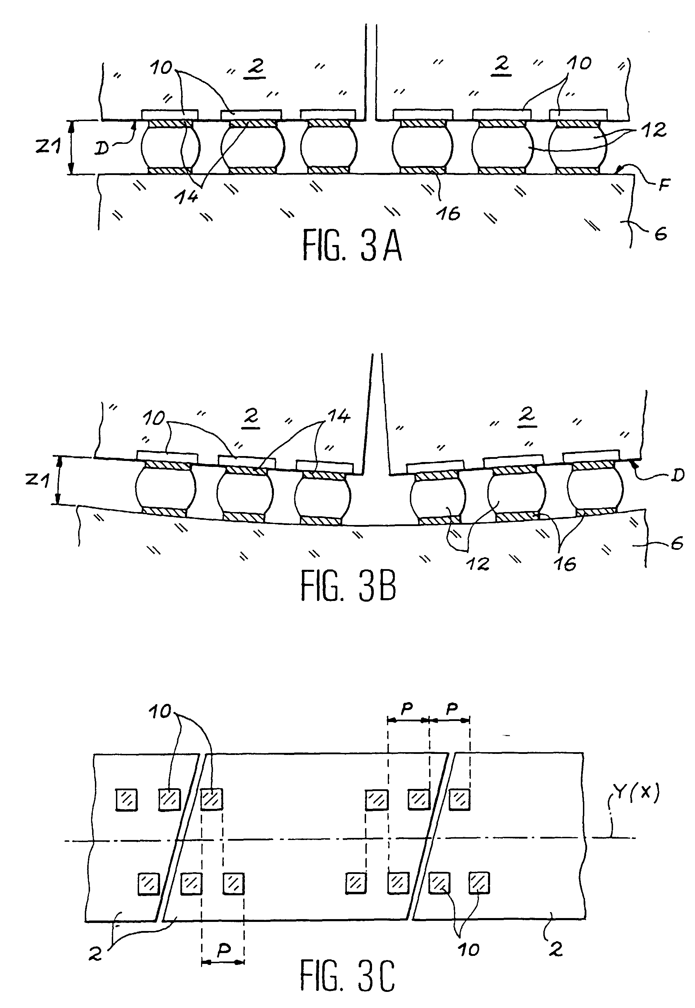

Les figures 3A à 3D explicitent certaines des spécifications que doivent respecter les modules de détection.

La figure 3A est une vue en coupe schématique qui montre des modules de détection 2 hybridés au support 6 dans un cas idéal.

On voit sur la figure 3A les photosites 10, associés à des plots 14 de connexion des modules 2, ainsi que les billes d'indium 12 reliant ces plots 14 à des plots de connexion 16 qui sont portés par une face F du support 6, cette face constituant un plan de référence des photosites.

La figure 3B illustre schématiquement, de façon exagérée, la déformation naturelle du support de réseau d'interconnexion 6.

La figure 3C illustre de façon schématique l'alignement des modules de détection 2, où les axes médians X de ces modules sont confondus avec la ligne théorique générale Y d'alignement des modules. Elle illustre aussi la continuité dans les positions des photosites 10 dont le pas P est conservé d'un module à l'autre (y compris entre deux modules).

Dans l'exemple de la figure 3C, le bord d'un photosite situé d'un côté de l'axe X est "aligné" avec le bord d'un photosite situé de l'autre côté de cet axe. En vue de la conservation du pas P, on choisit alors d'utiliser des modules en forme de parallélogramme.

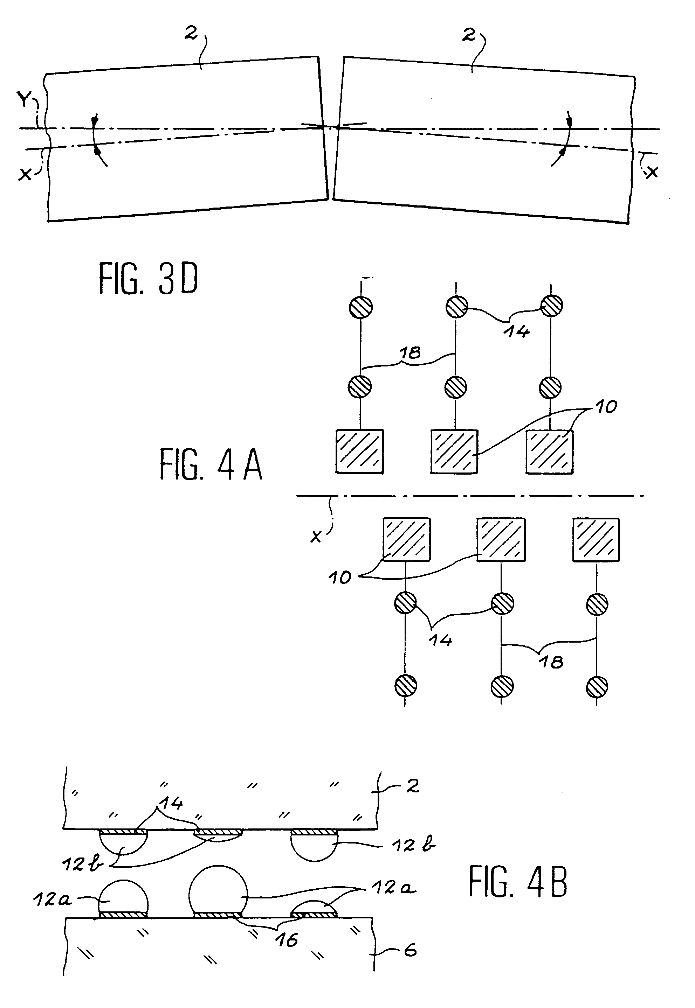

La figure 3D illustre schématiquement, de façon exagérée, le cas réel où ces axes médians X ne sont pas confondus avec cette ligne théorique générale d'alignement Y.

En revenant aux spécifications mentionnées plus haut, on précise que les modules de détection respectent en particulier la forme du "plan" de détection D.

Ce plan de détection est situé à l'altitude Z1 constante (figures 3A et 3B), par exemple égale à 20 µm, et suit la déformation naturelle du support de réseau d'interconnexion (qui peut être bombé ou, au contraire, creux).

Cette déformation est de l'ordre de 10 µm sur une tranche de silicium de diamètre égal à 100 mm (figure 3B).

Les modules de détection respectent également le "lacet" qui correspond à l'erreur de positionnement d'un module de détection par rapport aux modules voisins.

Il s'agit de l'angle que fait l'axe médian X de ce module avec la ligne théorique générale d'alignement Y, cette ligne étant définie par la technologie utilisée pour la fabrication du support de réseau d'interconnexion (figure 3D).

Malgré toutes ces erreurs relatives, le dispositif, dans l'état qu'il présente, répond aux spécifications qui lui sont demandées.

Comme on le verra par la suite, à partir de ces conditions et après déshybridation d'un module défectueux, l'invention permet de replacer très exactement un nouveau module en respectant les mêmes spécifications.

Les figures 4A et 4B permettent de comprendre ce qui se passerait si l'on essayait de remplacer un module de détection défectueux dans le dispositif de la figure 1.

La figure 4A montre la face d'un module de détection où se trouvent les surfaces sensibles des photosites 10 disposés en quinconce et placés de part et d'autre de l'axe médian X du module.

On voit également sur la figure 4A des liaisons électriques 18 permettant de relier les photosites 10 au module de lecture correspondant 4 (figure 1) par l'intermédiaire du support de réseau d'interconnexion 6.

On voit en outre sur la figure 4A les plots de connexion 14 que comporte chaque module de détection 2 et dont les surfaces sont mouillables par l'indium.

Ces plots sont bien entendu en contact électrique avec les liaisons électriques correspondantes 18.

Dans l'exemple représenté, chaque photosite 10 d'un module de détection est associé à deux plots 14 pour obtenir une redondance électrique et thermique ainsi qu'un meilleur maintien mécanique de ce module de détection sur le support de réseau d'interconnexion.

Lors de l'hybridation, qui est effectuée à la température de fusion de l'indium, chacun des plots de connexion du module de détection est très exactement recouvert par une bille d'indium qui résulte de la fusion d'une galette d'indium préalablement formée sur le support de réseau d'interconnexion (voir le document mentionné plus haut).

Pour remplacer un module défectueux 2, il convient d'abord d'effectuer une opération de déshybridation, c'est-à-dire d'extraction, de ce module.

Cette opération est également réalisée à la température de fusion de l'indium.

Dans ces conditions, les volumes 12a des billes d'indium restant sur le support de réseau d'interconnexion après cette opération d'extraction sont à la fois réduits par rapport aux volumes initiaux (une partie 12b de l'indium est restée sur le module déshybridé) et inhomogènes, comme le montre schématiquement la figure 4B.

Il existe donc un double risque pour le nouveau module destiné à remplacer le module défectueux, en ce qui concerne le respect des spécifications.

Il y a tout d'abord un risque de mauvaise position, de basculement et de décalage de l'altitude du plan de détection de ce nouveau module par rapport aux plans de détection des autres modules.

Il existe également un risque de réhybridation non garantie pour tous les photosites de ce nouveau module.

D'autres procédés sont décrits dans Patent Abstracts of Japan, vol 17, no. 599 (E-1455), 2.Nov. 1993 et JP-A-05183011 et dans IBM Tech. Disc. Bull. vol 25, no.2, Juillet 1982 p. 752-753.

La présente invention vise à remédier aux inconvénients précédents.

L'invention permet au nouveau module de détection de rayonnement de se retrouver très exactement dans la position du module de détection de rayonnement qu'il a remplacé.

L'invention permet d'hybrider ce nouveau module dans un environnement qui conserve l'intégralité du volume des billes d'indium.

Plus généralement, la présente invention permet à un module de remplacement de se retrouver très exactement dans la position d'un précédent module qu'il remplace, sur un support d'interconnexion (sur lequel était hybridé le précédent module), et d'hybrider ce module de remplacement dans un environnement qui conserve l'intégralité du volume des billes de soudure permettant l'hybridation.

Par "support d'interconnexion", on entend un substrat portant un réseau d'interconnexion et/ou un composant ou dispositif dont une partie est dédiée à l'interconnexion.

De façon précise, la présente invention a pour objet un procédé d'échange d'un premier module de détection hybridé à un support d'interconnexion par des billes de soudure , caractérisé en ce qu'on fabrique le support d'interconnexion en le munissant d'au moins un premier ensemble d'éléments de soudure destinés à l'hybridation du premier module de détection au support d'interconnexion et d'au moins un deuxième ensemble d'éléments de soudure destinés à l'hybridation d'un deuxième module de détection de remplacement du premier module de détection, en ce qu'on fabrique le premier module de détection en le munissant de plots de connexion, dont la surface est mouillable par la soudure et qui sont disposés de façon à se trouver respectivement en regard des éléments du premier ensemble d'éléments de soudure lors de l'hybridation, les zones de ce premier module de détection, qui sont destinées à se trouver en regard des éléments du deuxième ensemble d'éléments de soudure lors de cette hybridation, étant non mouillables par la soudure, en ce qu'on fabrique le module de détection de remplacement en munissant celui-ci de plots de connexion, dont la surface est mouillable par la soudure et qui sont disposés de façon à se trouver respectivement en regard des éléments du deuxième ensemble d'éléments de soudure lors de l'hybridation de ce module de détection de remplacement au support d'interconnexion, les zones de ce module de détection de remplacement, qui sont destinées à se trouver en regard des éléments du premier ensemble d'éléments de soudure lors de cette hybridation, étant non mouillables par la soudure, en ce que, pour échanger le premier module de détection qui a été hybridé au moyen du premier ensemble d'éléments de soudure, on déshybride ce premier module de détection et on hybride le module de détection de remplacement au moyen du deuxième ensemble d'éléments de soudure, en ce que le deuxième ensemble d'éléments de soudure se déduit du premier ensemble d'éléments de soudure par une rotation de 180°. autour d'un axe perpendiculaire à la face du support d'interconnexion qui porte ces premier et deuxième ensembles d'éléments de soudure et en ce que le module de détection de remplacement est hybridé au support d'interconnexion après avoir été mis dans une position se déduisant, par cette rotation, de la position occupée par le premier module de détection lorsque celui-ci était hybridé.

De préférence, les éléments de détection de chaque module sont répartis de manière symétrique par rapport à un axe perpendiculaire à la face du module qui porte ces éléments de détection.

Ceci permet d'utiliser des module de détection identiques pour réaliser l'hybridation et la réhybridation.

De préférence, afin d'assurer une redondance électrique et thermique et/ou un bon maintien mécanique dudit premier module et dudit module de remplacement, le support comprend deux premiers ensembles d'éléments de soudure et deux deuxièmes ensembles d'éléments de soudure.

Les éléments de soudure utilisés dans la présente invention pour les hybridations peuvent être des billes de soudure (qui sont préalablement formées sur le support).

Cependant, selon un mode de mise en oeuvre préféré de l'invention, les éléments de soudure de chaque premier et chaque deuxième ensembles sont des galettes de soudure.

Ceci permet de mettre en oeuvre la technique d'hybridation par auto-alignement qui est décrite dans le document mentionné plus haut.

La soudure peut être un matériau choisi dans le groupe comprenant l'indium, l'étain, le plomb et les alliages métalliques dont la température de fusion ne dépasse pas 350°C et qui contiennent de l'indium, de l'étain ou du plomb (et éventuellement d'autres matériaux comme par exemple le bismuth ou l'argent).

La présente invention sera mieux comprise à la lecture de la description d'exemples de réalisation donnés ci-après à titre purement indicatif et nullement limitatif, en faisant référence aux dessins annexés sur lesquels ;
- la figure 1, déjà décrite, est une vue en perspective schématique d'un dispositif connu de détection de rayonnement,
- la figure 2A, déjà décrite, montre des photosites que comprennent les modules de détection du dispositif de la figuré 1,
- la figure 2B, déjà décrite, est une vue en coupe schématique de ces modules de détection hybridés à un support de réseau d'interconnexion que comprend le dispositif de la figure 1,
- la figure 3A, déjà décrite, illustre schématiquement un cas idéal d'hybridation des modules de détection au support du dispositif de la figure 1,
- la figure 3B, déjà décrite, illustre schématiquement, de façon exagérée, un cas réel d'hybridation de ces modules,
- la figure 3C, déjà décrite, montre de façon schématique un cas idéal d'alignement des modules de détection du dispositif de la figure 1,
- la figure 3D, déjà décrite, illustre schématiquement, de façon exagérée, l'erreur de lacet qui existe dans la réalité pour ces modules de détection,
- la figure 4A, déjà décrite, montre schématiquement les photosites d'un module de détection, qui sont associés à des liaisons électriques reliant ces photosites à des modules de lecture que comprend le dispositif de la figure 1,
- la figure 4B, déjà décrite, illustre schématiquement la non-conservation du volume des billes d'indium permettant l'hybridation d'un module de détection, lorsque ce module est séparé du support de réseau d'interconnexion du dispositif de la figure 1,
- la figure 5A est une vue schématique et partielle d'un support de réseau d'interconnexion utilisable pour la mise en oeuvre d'un procédé conforme à la présente invention,
- la figure 5B est une vue schématique et partielle d'un module de détection utilisable avec le support représenté sur la figure 5A pour la mise en oeuvre de ce procédé conforme à la présente invention,
- la figure 5C illustre schématiquement ce procédé conforme à la présente invention,
- la figure 6A illustre schématiquement l'hybridation d'un module de détection au support de réseau d'interconnexion selon ce procédé conforme à l'invention,
- la figure 6B illustre schématiquement la déshybridation du module de détection de la figure 6A,
- la figure 7A illustre schématiquement le remplacement de ce module de détection par un autre module de détection au cours de ce procédé conforme à la présente invention, et
- la figure 7B illustre schématiquement l'hybridation de cet autre module de remplacement au support de réseau d'interconnexion.

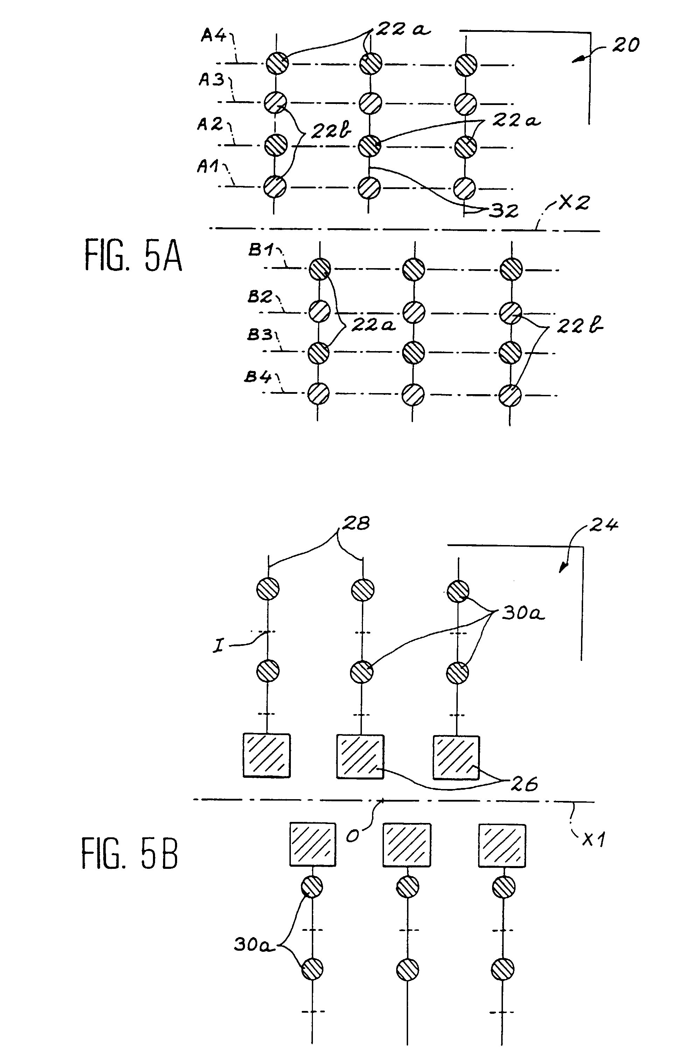

Un mode de mise en oeuvre particulier du procédé objet de l'invention va maintenant être expliqué en faisant référence aux figures 5A à 7B.

Ce mode de mise en oeuvre particulier est expliqué en prenant l'exemple du remplacement d'un module de détection de rayonnement qui est hybridé à un support de réseau d'interconnexion par exemple en silicium, au moyen de billes d'indium.

La figure 5A est une vue schématique et partielle de ce support de réseau d'interconnexion 20 en vue de dessus.

La figure 5A montre ainsi la face supérieure de ce support, qui porte des plots de connexion sur lesquels se trouvent des galettes d'indium 22a et 22b (ces plots de connexion étant de ce fait invisibles sur la figure 5A).

Le support 20 est représenté avant l'hybridation du module de détection.

Ce module de détection est schématiquement et partiellement représenté sur la figure 5B où il porte la référence 24.

La figure 5B montre la face de ce module de détection du côté de laquelle se trouve des photosites 26.

Le module 24 comprend aussi des liaisons électriques 28 qui relient les photosites à un circuit de lecture (non représenté) par l'intermédiaire du support 20 (lorsque ce module 24 est hybridé à ce support).

On voit également sur la figure 5B des plots de connexion 30a qui sont en contact électrique avec les liaisons 28.

Ces plots de connexion 30a sont mouillables par l'indium tandis que leur environnement ne l'est pas.

On voit sur la figure 5A des liaisons électriques 32 qui sont en contact électrique avec les galettes de soudure 22a et 22b par l'intermédiaire des plots de connexion non visibles sur la figure 5A.

Ces plots sont mouillables par l'indium tandis que leur environnement ne l'est pas.

Chacune des liaisons électriques 32 permet de transmettre le signal issu d'un photosite au circuit de lecture correspondant.

Ce signal va ainsi du photosite à ce circuit de lecture par l'intermédiaire de la liaison électrique 28 et de la liaison électrique 32 correspondantes.

Selon l'invention, pour que le module remplaçant le module 24 hybridé au support 20 puisse se retrouver très exactement dans la position de ce module 24, le module de remplacement est hybridé dans un environnement qui conserve l'intégralité du volume des billes d'indium formées au cours de l'hybridation du module 24 au support 20.

Pour ce faire, conformément à l'invention, on a doublé le nombre de galettes d'indium du support 20 par rapport à un support classique du genre de celui dont il a été question dans la description des figures 1 à 4B.

Une moitié des galettes est affectée au module 24 et l'autre moitié au module de remplacement.

Les plots mouillables par l'indium, qui se trouvent sur le module 24 et qui sont destinés à l'hybridation de ce module, sont situés de telle façon qu'ils se trouvent face à la moitié des galettes d'indium disposées sur le support 20 lors de l'hybridation de ce module 24.

Ainsi, après cette hybridation, chaque bille d'indium formée, qui est en contact avec un plot du support 20, assure une connexion électrique avec le plot correspondant du module 24.

L'autre moitié des billes d'indium formées au cours de l'hybridation se trouve en face de surfaces du module qui ne sont pas mouillables par l'indium, est aplatie au contact de ces surfaces du module et n'assure aucune connexion électrique.

Lors de la déshybridation (remplacement du module), ces billes applaties ne sont pas modifiées du point de vue du volume et prennent une forme quasiment sphérique.

Au cours de l'hybridation du module de remplacement, ces billes permettent l'installation de celui-ci par auto-alignement, très exactement dans la position occupée par le module 24 précédent.

Comme on le verra mieux par la suite, une disposition particulière des plots de connexion permet d'utiliser le même type de module aussi bien lors de la première hybridation (hybridation du module 24) que lors de l'hybridation du module de remplacement.

Il suffit de retourner le module de remplacement, par rapport à la position occupée par le module remplacé (lorsque celui-ci était hybridé), de façon que tous les plots de connexion de ce module de remplacement se trouvent en regard des billes d'indium qui n'étaient pas utilisées lors de l'hybridation du module 24.

Plus précisément, dans l'exemple représenté sur les figures 5A et 5B, les photosites du module 24 sont disposés en quinconce et se trouvent de part et d'autre de l'axe médian X1 de ce module.

Le support 20 a également un axe médian X2 que l'on met en coïncidence avec l'axe X1 lors de l'hybridation du module 24 et du support 20.

Les galettes d'indium 22a et 22b sont placées de part et d'autre de l'axe X2 qui constitue un axe de superposition.

Le support 20 pourrait ne comporter que deux galettes d'indium par photosite mais il en comporte de préférence un multiple de deux, par exemple quatre, comme on le voit sur la figure 5A, pour des raisons de redondance électrique et thermique ainsi que pour un meilleur maintien mécanique du module sur le support.

Le nombre de plots de connexion 30a (mouillables par l'indium) du module 24 est très exactement égal à la moitié du nombre total de galettes d'indium 22a et 22b du support 20.

Comme on le voit sur la figure 5A, les galettes d'indium se trouvent sur des lignes A1, A2, A3 et A4 placées d'un côté de l'axe X2 et parallèles à cet axe et sur d'autres lignes B1, B2, B3 et B4 également parallèles à l'axe X2 et placées de l'autre côté de cet axe X2.

Les plots du module 24, qui sont mouillables par l'indium, sont placés d'un côté de l'axe X1, de façon à pouvoir venir en contact avec les galettes d'indium 22a des lignes A2 et A4 et, de l'autre côté de l'axe X1, de façon à pouvoir venir en contact avec les galettes d'indium 22a des lignes B1 et B3.

Le module 24 comporte, non pas des plots de connexion, mais des zones non mouillables par l'indium, en correspondance avec les galettes d'indium des lignes A1 et A3.

De même, ce module 24 comporte, non pas des plots de connexion, mais des zones non mouillables par l'indium, en correspondance avec les galettes d'indium des lignes B2 et B4.

Ainsi, après déshybridation du module 24, les billes d'indium résultant des galettes d'indium des lignes A1, A3, B2 et B4, qui étaient en appui contre des zones non mouillables du module 24, restent intactes.

Le module de remplacement utilisé est identique au module 24.

Les plots de connexion dont est pourvu ce module de remplacement sont placés de la même façon que ceux du module 24.

En outre, la répartition des photosites de chacun de ces modules présente une symétrie par rapport à un axe perpendiculaire à la face portant ces photosites. La trace de cet axe sur cette face est référencée O dans la figure 5B.

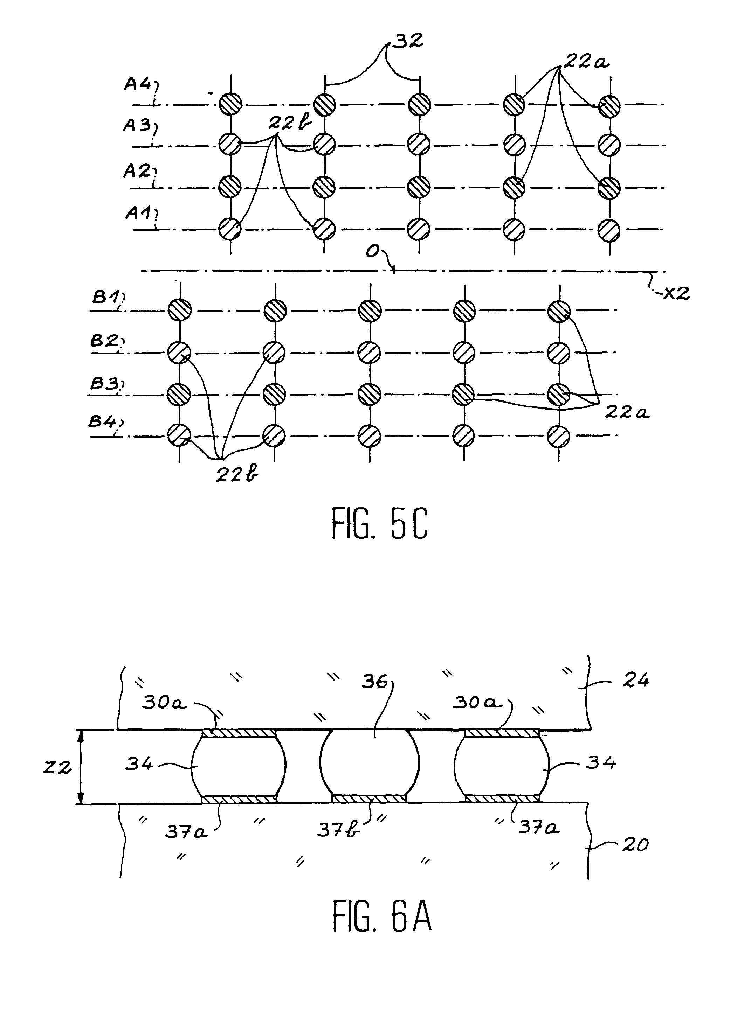

De plus, comme on le voit sur la figure 5C, les galettes d'indium 22b, qui n'ont pas servi lors de l'hybridation du module 24 et se trouvent sur les lignes A1, A3, B2 et B4, se déduisent des galettes d'indium 22a des lignes A2, A4, B1 et B3 qui ont été utilisées lors de l'hybridation du module 24 par une rotation de 180° autour d'un axe qui est perpendiculaire à la face du support portant les galettes d'indium et dont la trace porte la référence O sur la figure 5C.

On a utilisé la même référence O que précédemment car cet axe est confondu avec l'axe de symétrie dont la trace apparaît sur la figure 5B (lorsque le module de la figure 5B est hybridé au support). De plus, pour chaque module, le centre I de chaque zone non mouillable (figure 5B) se déduit, par cette symétrie axiale, du centre de l'un des plots 30a du module.

Avant l'hybridation du module de remplacement, on fait subir à celui-ci une rotation de 180° autour de cet axe O (la face de ce module de remplacement, sur laquelle se trouvent les plots de connexion, étant en regard de la face du support portant les billes d'indium et parallèle à cette face), par rapport à la position qu'occupait le module 24 lorsqu'il était hybridé.

Ainsi les plots de connexion du module de remplacement viennent en contact avec les billes correspondant aux galettes d'indium 22b des lignes A1, A3, B2 et B4, ces billes étant intactes après déshybridation du module 24.

La figure 6A est une vue en coupe schématique et partielle du module 24 hybridé au support de réseau d'interconnexion 20.

On voit sur la figure 6A deux billes d'indium 34 soudées d'un côté à des plots 37a du support 20 et de l'autre, à des plots 30a du module 24.

On voit également une bille d'indium 36 qui repose sur un plot 37b du support 20 mais qui n'est pas soudée au module de détection 24 puisqu'elle est en contact avec une surface non mouillable par l'indium de ce module 24.

Il n'y a pas de liaison électrique entre le support 20 et le module 24 au niveau de cette bille d'indium 36.

Selon des spécifications respectées, le module 24 se trouve à une distance Z2 du support 20.

En ce qui concerne l'hybridation du module 24, on se référera au document mentionné plus haut.

On précise simplement ici que, pour cette hybridation, les plots de connexion 30a du module 24 sont mis en contact avec les galettes d'indium correspondante 22a du support 20 et l'assemblage du module et du support obtenu est porté à la température de fusion de l'indium, d'où la formation des billes d'indium 34 et 36.

Après refroidissement, l'hybridation est réalisée.

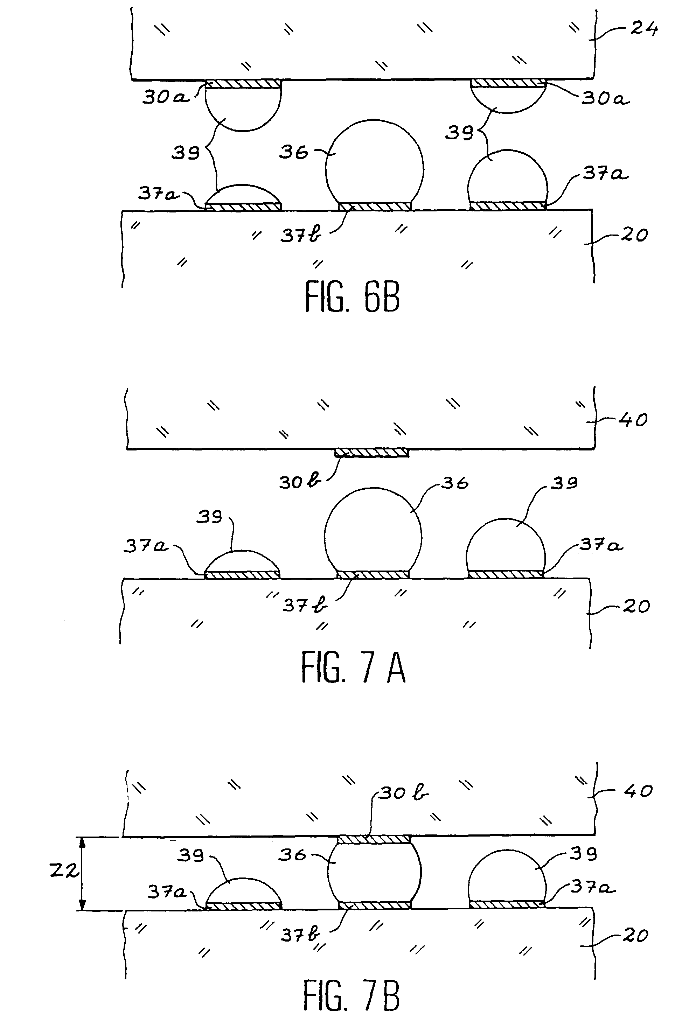

La figure 6B est une vue en coupe schématique et partielle du support 20 et du module 24 après déshybridation du module 24.

La bille d'indium 36, qui avait la forme d'une sphère applatie, a maintenant une forme quasiment sphérique, comme on le voit sur la figure 6B.

Au contraire, les billes 34, qui étaient soudées à des plots 30a et 37a, se retrouvent sur ces divers plots avec des volumes 39 qui sont différents et dont la distribution est complètement aléatoire.

La figure 7A est une vue en coupe schématique et partielle du module de remplacement 40 que l'on approche du support de réseau d'interconnexion 20 pour hybrider ce module 40.

Celui-ci comporte des plots de connexion tels que le plot 30b, qui sont destinés à venir en contact avec les billes d'indium 36 restées intactes.

Les volumes d'indium 39 restant sur les plots de connexion 37a du support 20 se trouvent en regard de zones du module de remplacement 40 qui ne sont pas mouillables par l'indium.

Pour l'hybridation du module de remplacement 40, les plots de connexion 30b de celui-ci sont mis en contact avec les billes 36 correspondantes du support 20 et l'ensemble obtenu est porté à la température de fusion de l'indium.

Après quoi, on laisse refroidir cet ensemble et l'hybridation est réalisée.

La figure 7B est une vue en coupe schématique et partielle du module de remplacement 40 hybridé sur le support de réseau d'interconnexion 20.

On voit sur cette figure 7B que les billes d'indium telles que la bille 36 sont soudées, d'un côté, aux plots du support 20 tels que le plot 37b et, de l'autre, aux plots du module 40 tels que le plot 30b.

Les volumes d'indium 39 ne sont pas soudés à ce module 40.

Cette hybridation du module 40 respecte les spécifications imposées.

L'hybridation du module de remplacement 40 permet à celui-ci de se trouver à la même distance Z2 du support 20 que précédemment.

## Revendications

1. Procédé d'échange d'un premier module de détection (24) hybridé à un support d'interconnexion (20) par des billes de soudure (34), caractérisé en ce qu'on fabrique le support d'interconnexion (20) en le munissant d'au moins un premier ensemble d'éléments de soudure (22a) destinés à l'hybridation du premier module de détection au support d'interconnexion et d'au moins un deuxième ensemble d'éléments de soudure (22b) destinés à l'hybridation d'un deuxième module de détection (40) de remplacement du premier module de détection, en ce qu'on fabrique le premier module de détection (24) en le munissant de plots de connexion (30a), dont la surface est mouillable par la soudure et qui sont disposés de façon à se trouver respectivement en regard des éléments (22a) du premier ensemble d'éléments de soudure lors de l'hybridation, les zones de ce premier module de détection, qui sont destinées à se trouver en regard des éléments (22b) du deuxième ensemble d'éléments de soudure lors de cette hybridation, étant non mouillables par la soudure, en ce qu'on fabrique le module de détection de remplacement (40) en munissant celui-ci de plots de connexion (30b), dont la surface est mouillable par la soudure et qui sont disposés de façon à se trouver respectivement en regard des éléments (22b) du deuxième ensemble d'éléments de soudure lors de l'hybridation de ce module de détection de remplacement (40) au support d'interconnexion (20), les zones de ce module de détection de remplacement, qui sont destinées à se trouver en regard des éléments (22a) du premier ensemble d'éléments de soudure lors de cette hybridation, étant non mouillables par la soudure, en ce que, pour échanger le premier module de détection (24) qui a été hybridé au moyen du premier ensemble d'éléments de soudure, on déshybride ce premier module de détection et on hybride le module de détection de remplacement (40) au moyen du deuxième ensemble d'éléments de soudure, en ce que le deuxième ensemble d'éléments de soudure (22b) se déduit du premier ensemble d'éléments de soudure (22a) par une rotation de 180° autour d'un axe (O) perpendiculaire à la face du support d'interconnexion (20) qui porte ces premier et deuxième ensembles d'éléments de soudure et en ce que le module de détection de remplacement (40) est hybridé au support d'interconnexion après avoir été mis dans une position se déduisant, par cette rotation, de la position occupée par le premier module de détection (24) lorsque celui-ci était hybridé.

2. Procédé selon la revendication 1, caractérisé en ce que les éléments de détection de chaque module (24, 40) sont répartis de manière symétrique par rapport à un axe perpendiculaire à la face du module qui porte ces éléments de détection.

3. Procédé selon l'une quelconque des revendications 1 et 2, caractérisé en ce que le support d'interconnexion comprend deux premiers ensembles d'éléments de soudure (22a) et deux deuxièmes ensembles d'éléments de soudure (22b).

4. Procédé selon l'une quelconque des revendications 1 à 3, caractérisé en ce que les éléments de soudure de chaque premier et chaque deuxième ensembles d'éléments de soudure sont des galettes de soudure (22a, 22b).

5. Procédé selon l'une quelconque des revendications 1 à 4, caractérisé en ce que la soudure est un matériau choisi dans le groupe comprenant l'indium, l'étain, le plomb et les alliages métalliques dont la température de fusion ne dépasse pas 350°C et qui contiennent de l'indium, de l'étain ou du plomb.

## Patentansprüche

1. Verfahren zum Austausch eines ersten, mittels Lotkugeln (34) auf einen Zwischenverbindungsträger (20) montierten Detektormoduls (24),
**dadurch gekennzeichnet,**
daß man den Zwischenverbindungsträger (20) herstellt, indem man ihn mit wenigstens einer erste Gruppe von Lotelementen (22a) versieht, bestimmt zur Montage des ersten Detektormoduls auf dem Zwischenverbindungsträger, sowie wenigstens einer zweiten Gruppe von Lotelementen (22b), bestimmt zur Montage eines zweiten, als Austausch für den ersten Detektormodul dienenden Detektormoduls (40), dadurch, daß man den ersten Detektormodul (24) herstellt, indem man ihn mit Verbindungskontaktelementen (30a) ausstattet, deren Oberfläche durch das Lot benetzbar ist, und die so angeordnet werden, daß sie bei der Montage jeweils Elementen (22a) der ersten Gruppe von Lotelementen gegenüberstehen, wobei diejenigen Zonen dieses ersten Detektormoduls, die dazu bestimmt sind, bei dieser Montage den Elementen (22b) der zweiten Gruppe von Lotelementen gegenüberzustehen, nicht durch das Lot benetzbar sind, dadurch, daß man den Austauschdetektormodul (40) herstellt, indem man diesen mit Verbindungskontaktelementen (30b) versieht, deren Oberfläche durch das Lot benetzbar ist und die so angeordnet sind, daß sie bei der Montage dieses Austauschdetektormoduls (40) auf den Zwischenverbindungsträger (20) jeweils Elementen (22b) der zweiten Gruppe von Lotelementen gegenüberstehen, wobei diejenigen Zonen dieses Austauschdetektormoduls, die dazu bestimmt sind, bei der Montage den Elementen (22a) der ersten Gruppe von Lotelementen gegenüberzustehen, nicht benetzbar sind durch das Lot, dadurch, daß zum Austauschen des ersten Detektormoduls (24), montiert mittels der ersten Gruppe von Lotelementen, man diesen ersten Detektormodul demontiert und man den Austauschdetektormodul (40) mittels der zweiten Gruppe von Lotelementen montiert, dadurch, daß die zweite Gruppe von Lotelementen (22b) von der ersten Gruppe von Lotelementen (22a) abgeleitet wird durch eine Drehung von 180°, um eine Achse (O), senkrecht zu der Fläche des Zwischenträgers (20), der diese erste und zweite Gruppe von Lotelementen trägt, und dadurch, daß der Austauschdetektionsmodul (40) auf den Zwischenverbindungsträger montiert wird, nachdem er in eine Position gebracht wurde, die sich durch diese Drehung von der Position herleiten läßt, die durch den ersten Detektormodul (24) eingenommen wurde, als dieser montiert war.

2. Verfahren nach Anspruch 1, dadurch gekennzeichnet, daß die Detektorelemente jedes Moduls (24, 40) symmetrisch verteilt sind bezüglich einer Achse, die senkrecht zu der diese Detektorelemente tragenden Fläche des Moduls ist.

3. Verfahren nach einem der Ansprüche 1 und 2, dadurch gekennzeichnet, daß der Zwischenverbindungsträger zwei erste Gruppen von Lotelementen (22a) und zwei zweite Gruppen von Lotelementen (22b) umfaßt.

4. Verfahren nach einem der Ansprüche 1 bis 3, dadurch gekennzeichnet, daß die Lotelemente der ersten und zweiten Lotelementegruppe Lotkugeln (22a, 22b) sind.

5. Verfahren nach einem der Ansprüche 1 bis 4, dadurch gekennzeichnet, daß das Lot ein Material ist, das aus der Gruppe ausgewählt wird, die Indium, Zinn, Blei und die metallischen Legierungen umfaßt, deren Schmelztemperatur 350°C nicht überschreitet und die Indium, Zinn oder Blei enthalten.

## Claims

1. Process for exchanging a first detection module (24) hybridized to an interconnection support (20) by welding bumps (34), characterized in that the interconnection support (20) is manufactured by providing it with at least one first group of welding elements (22a) for the hybridization of the first detection module to the interconnection support and at least one second group of welding elements (22b) for the hybridization of a second detection module (40) replacing the first detection module (24), in that the first detection module is manufactured by providing it with connection blocks (30a), whose surface is wettable by the weld and which are arranged in such a way as to be respectively located facing the elements (22a) of the first group of welding elements during hybridization, the zones of said first detection module intended for being positioned facing elements (22b) of the second group of welding elements during said hybridization being non-wettable by the weld, in that the replacement detection module (40) is manufactured by providing it with connection blocks (30b), whose surface is wettable by the weld and which are positioned so as to be respectively located facing elements (22b) of the second group of welding elements during the hybridization of said replacement detection module (40) on the interconnection support (20), the zones of this replacement detection module which are to be positioned facing elements (22a) of the first group of welding elements during said hybridization being non-wettable by the weld, in that, for exchanging the first detection module (24) hybridized by means of the first group of welding elements, dehybridization takes place of said first detection module and the replacement detection module (40) is hybridized by means of the second group of welding elements, in that the second group of welding elements (22b) is deduced from the first group of welding elements (22a) by a 180° rotation about an axis (0) perpendicular to the face of the interconnection support (20) carrying said first and second groups of welding elements and in that the replacement detection module (40) is hybridized on the interconnection support after having been placed in a position deduced, by said rotation, from the position occupied by the first detection module (24) when it was hybridized.

2. Process according to claim 1, characterized in that the detection elements of each module (24, 40) are distributed symmetrically with respect to an axis perpendicular to the face of the module carrying said detection elements.

3. Process according to either of the claims 1 and 2, characterized in that the interconnection support comprises two first groups of welding elements (22a) and two second groups of welding elements (22b).

4. Process according to any one of the claims 1 to 3, characterized in that the welding elements of each first and second groups of welding elements are welding wafers (22a, 22b).

5. Process according to any one of the claims 1 to 4, characterized in that the weld is of a material chosen from within the group including indium, tin, lead and metal alloys, whose melting point does not exceed 350°C and which contain indium, tin or lead.
